# EUROPEAN PATENT APPLICATION

(11) **EP 2 262 024 A1**
(43) Date of publication of application: **15.12.2010**
(21) Application number: 09382090.0
(22) Date of filing: 09.06.2009
(51) Int. Cl.: H01L 51/42, H01L 51/44

(54) **Optical cavity controlled fluorescent photovoltaic cell**

(71) Applicant: Institut de Ciències Fotòniques, Fundació Privada, 08860 Castelldefels, Barcelona (ES); Universitat Politècnica de Catalunya, 08034 Barcelona (ES); Université Libre de Bruxelles, 1050 Bruxelles (BE)
(72) Inventor: Martorell Pena, Jordi, 08860, Castelldefels (Barcelona) (ES); Vuong, Luat, 08860, Castelldefels (Barcelona) (ES); Kozyreff, Gregory, B-1050, Bruxelles (BE)
(74) Representative: Carpintero Lopez, Francisco

(57) **Abstract**

A photovoltaic cell comprising top (5) and bottom (8) electrodes and a photosensitive material (6, 7, 9) with a high quantum yield fluorescence between 0.3 and 1 is provided. The top electrode is of a semi-transparent material adapted to form an open optical cavity with a bottom electrode. The cavity controls the fluorescence of the photosensitive material.

## Description

### TECHNICAL FIELD

The present invention relates to photovoltaic cells. More in particular, the invention is related to solar cells using a fluorescent material or materials as the photosensitive material and the fluorescence being controlled by an optical cavity.

### STATE OF THE ART

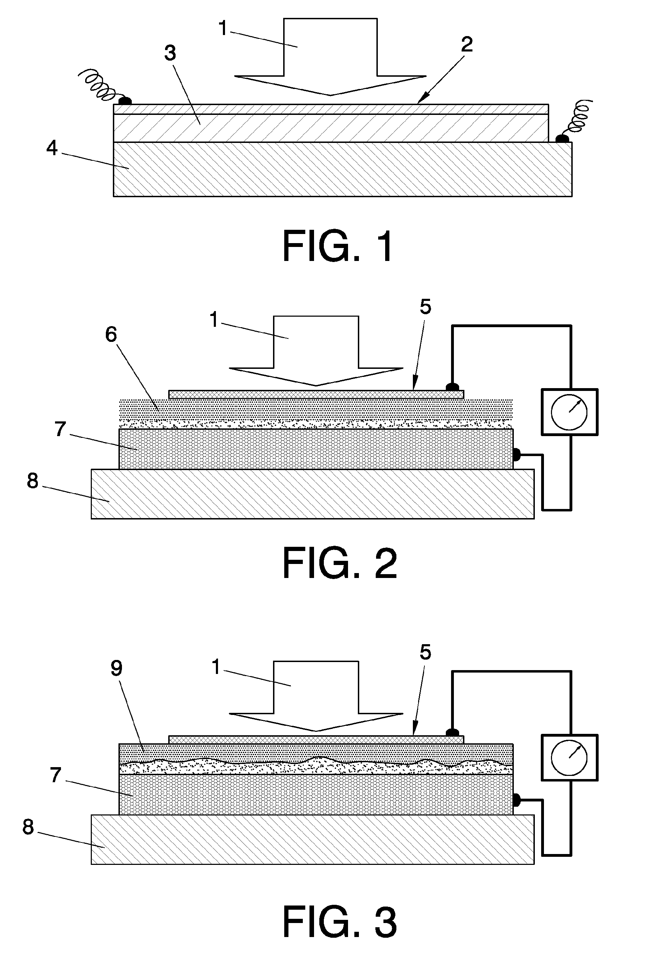

Photovoltaic cells can be fabricated based on merocyanine dyes with efficiencies that are close to 1%. Patent publication US4127738 A describes such solar cell. Other designs based on mixtures of dyes and merocyanine, polymerized merocyanine, or polymer and merocyanine have been shown to perform similarly to the merocyanine cell. Such a merocyanine cell is shown in FIG. 1. The layer of photosensitive material (3) is sandwiched between a bottom (4) and a top electrode (2), the bottom electrode comprising an element of a work function that is lower than the one of the element of the top electrode. Sun photon absorption in this cell results in the creation of excitons in the merocyanine layer that diffuse to the rectifying contact between the merocyanine and the low work function metal. Within the charge separation layer, electrons drift towards the metal while holes drift towards the opposite electrode through the merocyanine layer that behaves as a low hole mobility type semiconductor. Such type of photovoltaic cells present some interesting characteristics such as an open circuit voltage that may be as high as 1.2 V. On the other hand, these cells suffer from a small short circuit current limited mostly by the short lifetime of excitons. In merocyanine the energy of excitons is lost by recombination, mostly due to non-radiative transitions. It has been shown that because of such recombination processes, the optimal size of the merocyanine photovoltaic cell must be kept very thin to approximately 20 nm or less. On the other hand, the average absorption length within the absorption bandwidth of merocyanine can be assumed to be 100 nm. If one were able to make use of the entire absorption length, the short circuit current could be increased by, at least, five times, making the photovoltaic cells five times more efficient.

It is difficult to increase the short circuit current in these type of solar cells because one would have to control the exciton recombination mechanisms. Even if one were able to use the proper active material to eliminate all non-radiative decay mechanisms, a radiative loss mechanism would remain. Given the photovoltaic organic material, there is only one way to reduce such radiative decay, which is by changing the electromagnetic environment where the exciton is created. In photovoltaic applications a full inhibition is not necessary or desirable, since it would require an optically closed cavity where photons could neither enter nor escape. In fact, a partial inhibition of the fluorescence would be very desirable, since it could lead to an increase in the exciton diffusion current for active materials with a high fluorescence quantum yield. At the same time, by increasing the photon lifetime the active material can be made thinner and consequently the series resistance of the active layer may be reduced. Such a reduction results in an increase in the hole conductivity. In summary, the use of fluorescent materials as active layers in solar cells combined with the appropriate control on the fluorescence may lead to a rather significant increase in the short circuit current of photovoltaic cells.

### SUMMARY OF THE INVENTION

The object of the present invention is thus to control the fluorescence in cells that are comprised of a photosensitive material with a high quantum yield. By high quantum yield it is understood that one of the mechanisms for exciton decay is recombination by fluorescence, and that the quantum yield of this fluorescence is between 0.3 and 1. The quantum yield is determined by measuring the number of emitted photons relative to the number of photons adsorbed by the photosensitive material. The invention thus provides a cell which comprises a top electrode, a photosensitive material with a quantum yield of between 0.3 and 1, a bottom electrode and a substrate, wherein the top electrode comprises a semi-transparent material adapted to form an open optical cavity with the bottom electrode. The top electrode might comprise an element from the group Au, Ni, Ag or combinations thereof or a transparent conductive oxide and a multilayer dielectric mirror. In the latter case, the transparent oxide could be chosen from ITO, ZnO, SnO₂:F or their combinations and the dielectric could be chosen from the group TiO₂, SiO₂, ZnS, MgF, and combinations thereof. The bottom electrode should comprise a material having a lower work function than the material of the top electrode, like Al, Ti, Mg or mixtures thereof. Optionally, the cell might comprise an exciton blocking layer between the photosensitive material and the top electrode and/or a thin insulating layer interposed between the bottom electrode and the photosensitive material. The photosensitive material could be advantageously a hole conductor high quantum yield fluorescence compound or both a hole conductor high quantum yield fluorescence compound and an electron conductor high quantum yield fluorescent compound
like one of C₂₁H₂₁N₃O₂, C₁₇H₁₇NO₃, C₃₂H₃₁N₂O₃Cl, C₂₈H₃₁ClN₂O₃ or combinations thereof.

The optimal thickness of the bottom electrode is 1 nm to 50 nm and the thickness of the top electrode is at least 100 nm.

With the cavity formed by the two electrodes, the emission decay time of the exciton that occurs at longer wavelengths with respect to the wavelength of the absorbed sun photons is controlled, i.e. the fluorescence of the exciton at longer wavelengths than the wavelength of the absorbed photons can be inhibited. This control is a result of the dimensions of the optical cavity relative to the wavelength of the light to be emitted. Typically the thickness of the spacing occupied by the materials in between the electrodes should be less than half the wavelength of light to be emitted by the excitons. One may say that the wavelength of the light is too large for the light to propagate within the cavity and as a consequence, fluorescence or the emission of photons is inhibited.

### BRIEF DESCRIPTION OF THE FIGURES

To complete the description and in order to provide for a better understanding of the invention, a set of drawings is provided. Said drawings illustrate preferred embodiments of the invention, which should not be interpreted as restricting the scope of the invention, but just as examples of how the invention can be embodied. The drawings comprise the following figures:
FIG. 1 shows a cross-sectional view of a photovoltaic device according to the prior art.
FIG. 2 shows a cross-sectional view of the photovoltaic cell according to the invention in which the photosensitive material sandwiched between the two electrodes comprises one compound with a high quantum yield fluorescence.
FIG. 3 shows a cross-sectional view of the photovoltaic cell in which the photosensitive material sandwiched between the two electrodes comprises two or more compounds with a high quantum yield fluorescence.

### DETAILED DESCRIPTION OF THE INVENTION

The fluorescent compounds used as photosensitive material in the present invention might include a hole conductor high quantum yield fluorescence compound like C₂₁H₂₁N₃O₂ (Coumarin 30) or C₁₇H₁₇NO₃ (Coumarin 334) (figure 2, ref. 6). In another embodiment, the photosensitive material includes an hetero-junction of an electron conductor high quantum yield fluorescent compound like C₃₂H₃₁N₂O₃Cl(Rhodamine 101), C₂gH₃₁ClN₂O₃, (Rhodamine B) and a hole conductor high quantum yield fluorescent compound as C₂₁H₂₁N₃O₂, (Coumarin 30) or C₁₇H₁₇NO₃(Coumarin 334) (figure 3, ref. 9). The one or more fluorescent materials are integrated within an optical cavity structure with the objective to inhibit the emission of fluorescence photons to be generated from exciton recombination. The optical cavity is used to increase the emission decay time of the exciton that occurs at longer wavelengths with respect to the wavelength of the photons absorbed from the sun.

The optical cavity is formed by a bottom electrode (7) and a top electrode (5) on a substrate (8) separated by the materials in between (6, 7, 9). The bottom electrode comprises an element or elements that have a low work function (Al, Ti, Mg...). The latter could be deposited on top a solid substrate (glass, polymer, plastic...). By low work function it should be understood lower than the work function of the top electrode. The bottom electrode must be prepared as to be a good reflector for the fluorescent light emitted by the photosensitive material, while the other electrode must be partially transparent to the spectrum of the absorption band of the photosensitive material and be partially reflecting to the fluorescent light emitted by the photosensitive material. The thickness of this bottom electrode must be such that an optimal reflectivity is obtained (typically the thickness would be on the order of 100 nm or more). The top electrode should comprise an element or elements that have a high work function (Au, Ni, Ag...). The top electrode acts as a partially transparent mirror that lets the sun light through while at the same time together with the bottom electrode forms the open optical cavity for the photons resulting from the fluorescence of the material. The thickness of this electrode should range, typically, from 1 nm up to 50 nm. Alternatively, instead of a high work function element or elements, the top electrode may comprise the combination of a transparent conductive oxide (ITO, ZnO, SnO₂:F...) and a multilayer dielectric mirror (typically the dielectrics used would be: TiO₂, SiO₂, ZnS, MgF,...)transparent to the absorption spectrum of the photosensitive element or elements, and reflecting for the exciton fluorescence spectrum.

An exciton blocking layer (PEDOT:PSS...) between the photosensitive part and the top electrode may also be used. This layer prevents excitons or electrons to reach the top electrode while at the same time may act as a hole conductor. It may also be used to smooth the contact between the photosensitive material and the top electrode.

A thin insulating layer interposed between the bottom electrode and the photosensitive material may also be used.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims. In particular, top and bottom are relative terms that can be interchanged, i.e., the order of the electrodes might be changed so that the bottom electrode is partially transparent and the top electrode has the optimal reflectivity close to 100%.

## Claims

1. Photovoltaic cell comprising a top electrode, a photosensitive material with a quantum yield of between 0.3 and 1, a bottom electrode and a substrate **characterized in that** the top electrode comprises a semi-transparent material adapted to form an open optical cavity with the bottom electrode.

2. Photovoltaic cell according to any of the preceding claims wherein the top electrode comprises an element from the group Au, Ni, Ag or combinations thereof.

3. Photovoltaic cell according to claim 1 wherein the semi-transparent electrode comprises a transparent conductive oxide and a multilayer dielectric mirror.

4. Photovoltaic cell according to claim 3 wherein the transparent oxide is chosen from ITO, ZnO, SnO₂:F or their combinations.

5. Photovoltaic cell according to claims 3 or 4 wherein the dielectric is chosen from the group TiO₂, SiO₂, ZnS, MgF, and combinations thereof.

6. Photovoltaic cell according to any of the preceding claims wherein the bottom electrode comprises a material having a lower work function than the material of the top electrode.

7. Photovoltaic cell according to claim 6 wherein the low work function element is chosen from the group comprising Al, Ti, Mg or mixtures thereof.

8. Photovoltaic cell according to any of the preceding claims further comprising an exciton blocking layer between the photosensitive material and the top electrode.

9. Photovoltaic cell according to any of the preceding claims wherein a thin insulating layer is interposed between the bottom electrode and the photosensitive material.

10. Photovoltaic cell according to any of the preceding claims wherein the photosensitive material comprises a hole conductor high quantum yield fluorescence compound.

11. Photovoltaic cell according to any of the preceding claims wherein the photosensitive material comprises both a hole conductor high quantum yield fluorescence compound and an electron conductor high quantum yield fluorescent compound.

12. Photovoltaic cell according claim 11 wherein the fluorescence compounds comprise one of C₂₁H₂₁N₃O₂, C₁₇H₁₇NO₃, C₃₂H₃₁N₂O₃Cl, C₂₈H₃₁ClN₂O₃or combinations thereof.

13. Photovoltaic cell according to any of the previous claims, wherein the thickness of the bottom electrode is 1 nm to 50 nm.

14. Photovoltaic cell according to any of the previous claims, wherein the thickness of the top electrode is at least 100 nm.
